(19) Europäisches Patentamt / European Patent Office / Office européen des brevets

(11) **EP 3 312 992 A1**

(12) **DEMANDE DE BREVET EUROPEEN**

(43) Date de publication:
**25.04.2018   Bulletin 2018/17**

(51) Int Cl.:
**H03K 17/082** (2006.01)        **H03K 17/16** (2006.01)

(21) Numéro de dépôt: **17197826.5**

(22) Date de dépôt: **23.10.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **21.10.2016   FR 1660240**

(71) Demandeur: **VALEO EQUIPEMENTS ELECTRIQUES MOTEUR**
**94046 Créteil Cedex (FR)**

(72) Inventeurs:
• HADJELIS, Bruno
  **95 892 CERGY PONTOISE (FR)**
• PLAIDEAU, Michel
  **95892 CERGY PONTOISE (FR)**

(74) Mandataire: **Cardon, Nicolas**
**Valeo Systèmes de Contrôle Moteur**
**Immeuble Le Delta**
**14, avenue des Béguines**
**95800 Cergy St Christophe (FR)**

(54)  **SYSTÈME D'INTERRUPTEUR ET CONVERTISSEUR ÉLECTRIQUE COMPORTANT UN TEL SYSTÈME D'INTERRUPTEUR**

(57)    Le système d'interrupteur comporte : - un interrupteur principal ($104_1$) présentant une première borne ($D_1$) et une deuxième borne ($S_1$) entres lesquelles un courant principal ($i_{DS1}$) est destiné à passer, et une borne de commande ($G_1$) destinée à se décharger selon une vitesse de décharge en fournissant un courant de décharge ($i_{G1}$), pour faire passer l'interrupteur principal ($104_1$) d'un état fermé à un état ouvert; - une interface ($118_1$) présentant une résistance d'interface destinée à être traversée par le courant de décharge ($i_{G1}$), de sorte que la vitesse de décharge dépende de la résistance d'interface.

L'interface ($118_1$) comporte un composant résistif ($120_1$) présentant une résistance variable participant à la résistance d'interface, et le système d'interrupteur comporte en outre un circuit de commande ($122_1$) du composant résistif ($120_1$) conçu, lorsque le courant principal ($i_{DS1}$) diminue, pour faire varier la résistance variable de sorte que la résistance d'interface augmente, afin de diminuer la vitesse de décharge de la borne de commande ($G_1$).

**Figure 2**

# Description

## DOMAINE TECHNIQUE

La présente invention concerne le domaine des interrupteurs commandés, en particulier dans des applications où ces interrupteurs sont destinés à être parcourus par des courants supérieurs à 100 A.

## ARRIÈRE-PLAN TECHNOLOGIQUE

La demande internationale PCT publiée sous le numéro WO 2014/009668 A1 décrit un système d'interrupteur comportant :

- un interrupteur principal présentant :

  - une première borne et une deuxième borne entres lesquelles un courant principal est destiné à passer, et
  - une borne de commande destinée à se décharger selon une vitesse de décharge en fournissant un courant de décharge, pour faire passer l'interrupteur principal d'un état fermé à un état ouvert,

- une interface présentant une résistance d'interface destinée à être traversée par le courant de décharge, de sorte que la vitesse de décharge dépend de la résistance d'interface.

Dans la publication précédente, il est prévu d'injecter un courant sur la borne de décharge pour diminuer le courant de décharge et donc la vitesse de décharge de la borne de commande. Ainsi, l'ouverture de l'interrupteur est ralenti et la variation du courant principal est limitée.

Cette solution pour limiter la variation du courant principal présente comme inconvénient que l'injection de courant nécessite de connecter la borne de commande de l'interrupteur à une source de tension. Ainsi, en cas de défaillance du système d'injection de courant, il est possible que la borne de commande soit rechargée de manière intempestive et provoque une fermeture non souhaitée de l'interrupteur.

L'invention a pour but de proposer un système d'interrupteur permettant de remédier, au moins en partie, aux inconvénients de la publication précédente.

## RÉSUMÉ DE L'INVENTION

À cet effet, il est proposé un système d'interrupteur comportant :

- un interrupteur principal présentant :

  - une première borne et une deuxième borne entres lesquelles un courant principal est destiné à passer, et
  - une borne de commande destinée à se décharger selon une vitesse de décharge en fournissant un courant de décharge, pour faire passer l'interrupteur principal d'un état fermé à un état ouvert,

- une interface présentant une résistance d'interface destinée à être traversée par le courant de décharge, de sorte que la vitesse de décharge dépend de la résistance d'interface,

le système d'interrupteur étant caractérisé en ce que l'interface ($118_1$; $118_1$') comporte un composant résistif ($120_1$; $120_1$') présentant une résistance variable participant à la résistance d'interface,
et en ce qu'il comporte en outre :

- un circuit de commande ($122_1$; $502_1$' :$602_1$) du composant résistif ($120_1$; $120_1$'), conçu, lorsque le courant principal ($i_{DS1}$; $i_{DS1}$') diminue, pour faire varier la résistance variable de sorte que la résistance d'interface augmente, afin de diminuer la vitesse de décharge de la borne de commande ($G_1$; $G_1$').

Grâce à l'invention, aucune injection de courant n'est nécessaire Ainsi, le système d'interrupteur selon l'invention est plus fiable.

De façon optionnelle, le composant résistif est un interrupteur commandable.

De façon optionnelle également, l'interrupteur commandable est un MOSFET.

De façon optionnelle également, l'interrupteur commandable est un MOSFET à déplétion.

De façon optionnelle également, l'interface comporte en outre une ou plusieurs résistances fixes combinée(s) avec le composant résistif pour participer à la résistance d'interface.

De façon optionnelle également, le circuit de commande est destiné à être connecté aux bornes d'une inductance parcourue par le courant principal afin de recevoir une tension d'inductance présente aux bornes de cette inductance, et le circuit de commande est conçu pour commander le composant résistif à partir de la tension d'inductance.

De façon optionnelle également, le circuit de commande comporte un transformateur comportant un bobinage primaire connecté aux bornes de l'inductance et un bobinage secondaire destiné à fournir un signal de mesure représentatif de la tension d'inductance, le circuit de commande étant conçu pour commander le composant résistif à partir de la tension de mesure.

De façon optionnelle également, le circuit de commande comporte en outre un circuit multiplicateur conçu pour multiplier le signal de mesure par une constante prédéterminée pour fournir une tension de commande appliquée au composant résistif.

De façon optionnelle également, le bobinage primaire présente une inductance d'au moins 1 μH.

De façon optionnelle également, le circuit de commande comporte un interrupteur commandable connecté à une borne de commande du composant résistif, et le circuit de commande est conçu pour commander l'interrupteur commandable à partir de la tension d'inductance, lorsque le courant principal diminue, afin de fermer l'interrupteur commandable pour connecter sa borne de commande à un potentiel destiné à faire varier la résistance variable de sorte que la résistance d'interface augmente.

De façon optionnelle également, dans lequel l'interrupteur commandable est conçu pour être commandé en se voyant appliquer une tension de commande, le circuit de commande comporte un circuit de précharge conçu pour appliquer une tension de commande prédéterminée en l'absence de diminution du courant principal, et le circuit de commande est conçu, lorsque le courant principal diminue, pour appliquer à l'interrupteur commandable une tension de commande qui est la somme de la tension de commande prédéterminée et d'une tension complémentaire dérivée de la tension d'inductance.

Il est également proposé un convertisseur électrique comportant au moins deux bras de commutation ayant chacun deux interrupteurs connectés l'un à l'autre en un point milieu, et dans lequel chacun d'au moins un des interrupteurs, de préférence les deux, fait partie d'un système d'interrupteur selon l'invention.

Il est également proposé un bras de commutation comportant :

- un système d'interrupteur selon l'invention, l'interrupteur principal étant appelé premier interrupteur principal,
- un deuxième interrupteur principal,

dans lequel le premier interrupteur principal et le deuxième interrupteur principal sont connectés l'un à l'autre en un point milieu destiné à être connecté à une bobine d'une machine électrique,

dans lequel le premier interrupteur principal est en outre destiné à être connecté à une borne positive d'une source de tension continue,

dans lequel le deuxième interrupteur principal est en outre destiné à être connecté à une borne négative d'une source de tension continue,

dans lequel le circuit de commande est destiné à être connecté aux bornes d'une branche comportant, dans l'ordre : une première inductance, le point milieu, et une deuxième inductance, afin de recevoir une tension de branche présente aux bornes de cette branche, et

dans lequel le circuit de commande est conçu pour commander le composant résistif à partir de la tension de branche.

De façon optionnelle, le circuit de commande comporte un interrupteur commandable connecté à une borne de commande du composant résistif, et dans lequel le circuit de commande est conçu pour commander l'interrupteur commandable à partir de la tension de branche, lorsque le courant principal diminue, afin de fermer l'interrupteur commandable pour connecter la borne de commande du composant résistif à un potentiel destiné à faire varier la résistance variable de sorte que la résistance d'interface augmente.

Il est également proposé un convertisseur électrique comportant au moins deux bras de commutation dont l'un au moins est conforme à l'invention.

DESCRIPTION DES FIGURES

La figure 1 est un circuit électrique d'un convertisseur électrique mettant en oeuvre l'invention.

La figure 2 est un circuit électrique d'un circuit de commande d'un interrupteur du convertisseur électrique de la figure 1.

La figure 3 est un ensemble de chronogramme représentant l'évolution au cours du temps de grandeurs électriques du circuit électrique de la figure 2.

La figure 4 est un ensemble de chronogramme représentant l'évolution au cours du temps de grandeurs électriques avec un circuit de commande selon l'état de la technique.

La figure 5 est un circuit électrique d'un circuit de commande d'interrupteur du convertisseur électrique de la figure 1, selon une variante de l'invention.

La figure 6 est un circuit électrique d'un circuit de commande d'interrupteur du convertisseur électrique de la figure 1, selon une autre variante de l'invention.

DESCRIPTION DÉTAILLÉE

Dans la description qui va suivre, une grandeur électrique nulle et une grandeur électrique négligeable devant les autres grandeurs électriques de même nature. Une grandeur électrique très grande est une grandeur électrique au moins 100 fois, de préférence au moins 1 000 fois, plus grande que les autres grandeurs électriques de même nature.

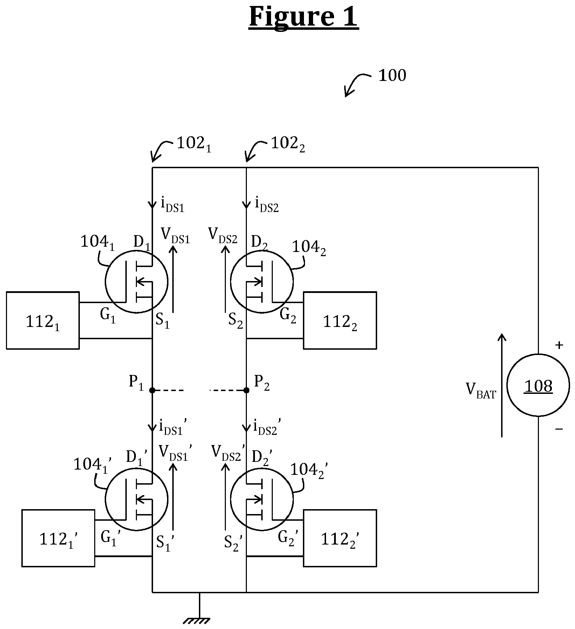

En référence à la figure 1, un convertisseur électrique 100 mettant en oeuvre l'invention va à présent être décrit.

Le convertisseur électrique 100 est par exemple un onduleur ou un redresseur, ou même un convertisseur continu/continu.

Le convertisseur électrique 100 comporte plusieurs bras de commutation. Dans l'exemple décrit, le convertisseur électrique 100 comporte deux bras de commutation, désignés respectivement par les références $102_1$ et $102_2$. Dans la suite de la description, l'indice « 1 » sera utilisé pour les éléments se rapportant au premier bras de commutation $102_1$, tandis que l'indice « 2 » sera utilisé pour les éléments se rapportant au deuxième

bras de commutation $102_2$.

Chaque bras de commutation $102_1$, $102_2$ comporte un interrupteur de côté haut $104_1$, $104_2$ et un interrupteur de côté bas $104_1'$, $104_2'$. Dans la suite de la description, le signe prime « ' » sera utilisé pour désigner les éléments se rapportant au côté bas.

Chaque interrupteur $104_1$, $104_1'$, $104_2$, $104_2'$ présente une première borne $D_1$, $D_1'$, $D_2$, $D_2'$, une deuxième borne $S_1$, $S_1'$, $S_2$, $S_2'$ et une borne de commande $G_1$, $G_1'$, $G_2$, $G_2'$.

Dans l'exemple décrit, les interrupteurs $104_1$, $104_1'$, $104_2$, $104_2'$ sont des transistors à effet de champ à grille isolée ou MOSFET (de l'anglais « Metal Oxide Semiconductor Field Effect Transistor ») présentant un drain, une source et une grille, formant respectivement la première borne, la deuxième borne et la borne de commande. Par soucis de clarté, les termes « drain », « source » et « grille » seront ainsi utilisés dans la suite de la description à la place des termes « première borne », « deuxième borne » et « borne de commande ».

Pour chaque interrupteur $104_1$, $104_1'$, $104_2$, $104_2'$, le drain $D_1$, $D_1'$, $D_2$, $D_2'$ et la source $S_1$, $S_1'$, $S_2$, $S_2'$ présentent entre eux une tension drain-source $V_{DS1}$, $V_{DS1}'$, $V_{DS2}$, $V_{DS2}'$ et un courant drain-source $i_{DS1}$, $i_{DS1}'$, $i_{DS2}$, $i_{DS2}'$ s'écoule entre eux. La grille $G_1$, $G_1'$, $G_2$, $G_2'$ et la source $S_1$, $S_1'$, $S_2$, $S_2'$ présentent entre elles une tension grille-source $V_{GS1}$, $V_{GS1}'$, $V_{GS2}$, $V_{GS2}'$ définissant l'état, ouvert ou fermé, de l'interrupteur $104_1$, $104_1'$, $104_2$, $104_2'$.

Plus précisément, l'interrupteur $104_1$, $104_1'$, $104_2$, $104_2'$ est conçu pour prendre l'état ouvert lorsque la tension grille-source $V_{GS1}$, $V_{GS1}'$, $V_{GS2}$, $V_{GS2}'$ est à une valeur d'ouverture de l'interrupteur $104_1$, $104_1'$, $104_2$, $104_2'$. Dans l'exemple décrit, la valeur d'ouverture est une valeur basse, par exemple nulle. Dans l'état ouvert, le courant drain-source $i_{DS1}$ est nul et la tension drain-source $V_{DS1}$, $V_{DS1}'$, $V_{DS2}$, $V_{DS2}'$ est non-nulle.

En outre, l'interrupteur $104_1$, $104_1'$, $104_2$, $104_2'$ est conçu pour prendre l'état fermé lorsque la tension grille-source $V_{GS1}$, $V_{GS1}'$, $V_{GS2}$, $V_{GS2}'$ est à une valeur de fermeture de l'interrupteur $104_1$, $104_1'$, $104_2$, $104_2'$. Dans l'exemple décrit, la valeur de fermeture est une valeur haute, par exemple 10V ou plus. Dans l'état fermé, le courant drain-source $i_{DS1}$ est non-nul et la tension drain-source $V_{DS1}$, $V_{DS1}'$, $V_{DS2}$, $V_{DS2}'$ est nulle.

Pour chaque bras de commutation $102_1$, $102_2$, la source $S_1$, $S_2$ de l'interrupteur de côté haut $104_1$, $104_2$ et le drain $D_1'$, $D_2'$ de l'interrupteur de côté bas $104_1'$, $104_2'$ sont connectés l'un à l'autre en un point milieu P1, P2 destiné à être connecté à une bobine (symbolisée par des traits pointillés) d'une machine électrique telle qu'un moteur électrique.

Les bras de commutation $102_1$, $102_2$ sont connectés à une source de tension continue 108, telle qu'une batterie ou un condensateur chargé, fournissant une tension $V_{BAT}$. Plus précisément, pour chaque bras de commutation $102_1$, $102_2$, le drain $D_1$, $D_2$ de l'interrupteur de côté haut $104_1$, $104_2$ est connecté à une borne positive + de la source de tension continue 108, tandis que la source $S_1'$, $S_2'$ de l'interrupteur de côté bas $104_1'$, $104_2'$ est connecté à une borne négative (-) de la source de tension continue 108 (la borne négative (-) étant généralement connectée à une masse électrique).

Le convertisseur électrique 100 comporte en outre, pour chaque interrupteur $104_1$, $104_1'$, $104_2$, $104_2'$, un circuit de commande $112_1$, $112_1'$, $112_2$, $112_2'$ respectif, les deux formant ensemble un système d'interrupteur.

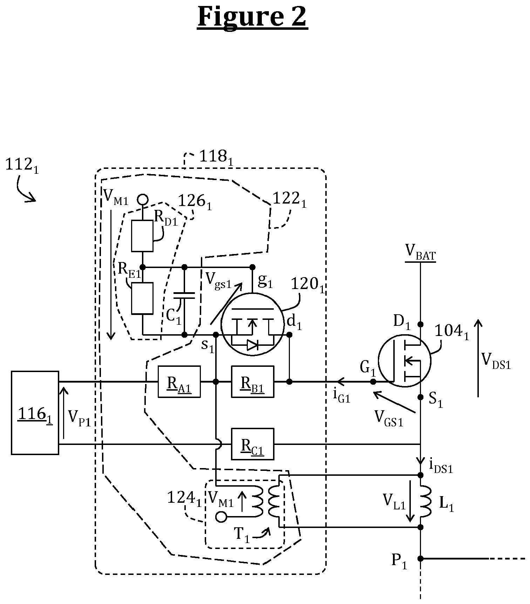

En référence à la figure 2, le circuit de commande $112_1$ de l'interrupteur de côté haut $104_1$ va à présent être décrit plus en détail, sachant que les autres circuits de commande $112_1'$, $112_2$, $112_2'$ sont identiques.

Le circuit de commande $112_1$ comporte tout d'abord un pilote $116_1$ conçu pour fournir une tension de pilotage $V_{P1}$ prenant sélectivement la valeur d'ouverture et la valeur de fermeture de l'interrupteur $104_1$.

Le circuit de commande $112_1$ comporte en outre une interface $118_1$ connectée, d'un côté, au pilote $116_1$ pour recevoir la tension de pilotage $V_{P1}$ et, d'un autre côté, entre la grille G1 et la source $S_1$ de l'interrupteur $104_1$. L'interface $118_1$ est destinée à définir la vitesse à laquelle la tension grille-source $V_{GS1}$ rejoint la tension de pilotage $V_{P1}$, et donc la vitesse de commutation de l'interrupteur $104_1$.

Plus précisément, lorsque la tension de pilotage $V_{P1}$ est à la valeur de fermeture, la grille $G_1$ est destinée à se décharger par rapport à la source $S_1$ selon un vitesse de décharge en fournissant un courant de décharge $i_{G1}$ vers l'interface $118_1$ pour que la tension $V_{GS1}$ rejoigne la valeur de fermeture. Lorsque la tension de pilotage $V_{P1}$ est à la valeur d'ouverture, la grille $G_1$ est destinée à se charger selon un vitesse de charge en recevant un courant de charge (de sens inverse au courant de décharge $i_{G1}$ représenté sur la figure 2) depuis l'interface $118_1$ pour que la tension $V_{GS1}$ rejoigne la valeur d'ouverture.

L'interface $118_1$ présente une résistance d'interface $R_I$ destinée à être traversée par le courant de décharge $i_{G1}$, de sorte que la vitesse de décharge - et donc la vitesse d'ouverture de l'interrupteur $104_1$ - dépende de la résistance d'interface $R_I$. Le courant de charge est également destiné à traverser la résistance d'interface $R_I$, de sorte que la vitesse de charge - et donc la vitesse de fermeture de l'interrupteur $104_1$ - dépende de la résistance d'interface $R_I$.

Il existe des inductances parasites au niveau du drain $D_1$ et de la source $S_1$ de l'interrupteur $104_1$ provenant des connexions de ces bornes. L'inductance parasite de la source $S_1$ est représentée sur la figure 2 et notée $L_1$. L'inductance parasite $L_1$ est destinée à être traversée par le courant drain-source $i_{DS1}$. Lors de l'ouverture de l'interrupteur $104_1$, le courant drain-source $i_{DS1}$ diminue et provoque l'apparition d'une tension d'inductance $V_{L1}$ négative, ce qui provoque l'apparition d'une surtension de la tension drain-source $V_{DS1}$. Or, cette surtension peut détériorer l'interrupteur $104_1$.

Pour limiter cette surtension, l'interface $118_1$ est

conçue pour limiter la variation du courant drain-source $i_{DS1}$. Comme cela va être expliqué par la suite, cet effet est obtenu en faisant varier la résistance d'interface $R_I$ au moment opportun.

**[0042]** Ainsi, l'interface $118_1$ comporte une ou plusieurs résistances fixes $R_{A1}$, $R_{B1}$, $R_{C1}$ combinée(s) avec au moins un composant résistif $120_1$ pour former la résistance d'interface $R_I$. Dans l'exemple décrit, le composant résistif $120_1$ est en parallèle de la résistance fixe $R_{B1}$. En outre, le composant résistif $120_1$ et la résistance fixe $R_{B1}$ sont en série de la résistance fixe $R_{A1}$ et de la résistance fixe $R_{C1}$. De préférence, la résistance $R_{C1}$ est connectée entre la source $S_1$ et le pilote $116_1$, afin de protéger le pilote $116_1$ de la tension $V_{L1}$.

**[0043]** Le composant résistif $120_1$ présente une résistance variable Rv qui peut être commandée comme cela sera décrit par la suite. La résistance d'interface $R_I$ est ainsi donnée dans l'exemple décrit par la formule :

$$R_I = R_{A1} + R_{C1} + \frac{R_V \cdot R_{B1}}{R_V + R_{B1}}$$

**[0044]** La résistance variable Rv participe donc à la résistance d'interface $R_I$, de sorte que, lorsque la résistance variable Rv est nulle, la résistance d'interface $R_I$ est à un minimum $R_{I_min}$ valant :

$$R_{I_min} = R_{A1} + R_{C1}$$

et de sorte que, lorsque la résistance variable Rv est très grande, la résistance d'interface $R_I$ est à un maximum $R_{I_max}$ valant :

$$R_{I_max} = R_{A1} + R_{C1} + R_{B1}$$

**[0045]** Dans l'exemple décrit, le composant résistif $120_1$ est un MOSFET comportant un drain $d_1$, une source $s_1$ et une grille $g_1$. Une tension source-grille $V_{gs1}$ est destinée à être présentée entre la grille $g_1$ et la source $s_1$, cette tension grille-source $V_{gs1}$ commande le MOSFET en définissant l'état, ouvert, fermé voire intermédiaire, du composant résistif $120_1$ et donc la résistance variable Rv. Dans l'exemple décrit, le MOSFET est à déplétion, c'est-à-dire qu'il est conçu pour être dans un état fermé (résistance variable Rv nulle) lorsque la tension grille-source $V_{gs1}$ est positive ou nulle, dans un état intermédiaire (résistance variable $R_V$ finie) lorsque la tension grille-source $V_{gs1}$ est négative jusqu'à un seuil S négatif (par exemple compris entre -1 V et -5 V) et dans un état ouvert (résistance variable $R_V$ très grande) lorsque la tension grille-source $V_{gs1}$ est inférieure au seuil S.

**[0046]** L'interface $118_1$ comporte en outre un circuit de commande $122_1$ du composant résistif $120_1$ en fonction de la tension d'inductance $V_{L1}$. Le circuit de commande $122_1$ est conçu pour faire varier la résistance variable Rv de sorte que la résistance d'interface $R_I$ augmente lorsque la tension d'inductance $V_{L1}$ augmente (selon le sens indiqué sur la figure 2) et diminue lorsque la tension d'inductance $V_{L1}$ diminue ou devient négative (toujours selon le sens indiqué sur la figure 2). Dans l'exemple décrit, le circuit de commande $122_1$ est conçu pour fournir la tension grille-source $V_{gs1}$ en fonction de la tension d'inductance $V_{L1}$.

**[0047]** Le circuit de commande $122_1$ comporte un circuit de mesure $124_1$ de la tension d'inductance $V_{L1}$ connecté aux bornes de l'inductance $L_1$ et conçu pour fournir une tension de mesure $V_{M1}$ représentative de la tension d'inductance $V_{L1}$.

**[0048]** Dans l'exemple décrit, le circuit de mesure $124_1$ comporte un transformateur $T_1$ comportant un bobinage primaire connecté aux bornes de l'inductance $L_1$ et un bobinage secondaire destiné à fournir la tension de mesure $V_{M1}$. Dans l'exemple décrit, le transformateur $T_1$ présente un rapport de transformation négatif, par exemple égal à -1. Ainsi, avec l'orientation de la tension de mesure $V_{M1}$ illustrée sur la figure 2, la tension de mesure $V_{M1}$ est négative lorsque la tension d'inductance $V_{L1}$ est négative, et positive lorsque la tension d'inductance $V_{L1}$ est positive. De préférence, le bobinage primaire présente une inductance d'au moins 1 $\mu$H de manière à ce que le courant dans le bobinage primaire soit négligeable par rapport au courant drain-source $i_{DS1}$. Ainsi, la quasi-totalité du courant drain-source $i_{DS1}$ traverse l'inductance $L_1$.

**[0049]** Le circuit de commande $122_1$ comporte en outre un circuit multiplicateur $126_1$ conçu pour multiplier la tension de mesure $V_{M1}$ par une constante prédéterminée K. Dans l'exemple décrit, le circuit multiplicateur $126_1$ est un pont diviseur de tension de sorte que la constante prédéterminée K est inférieure à 1. Le pont diviseur de tension comporte une résistance $R_{D1}$ et une résistance $R_{E1}$ connectées l'une à l'autre par des premières bornes respectives en un point milieu lui-même connecté à la grille $g_1$. La résistance $R_{D1}$ et la résistance $R_{E1}$ présentent en outre des deuxièmes bornes respectives connectées respectivement aux deux bornes du bobinage secondaire du transformateur $T_1$. Grâce à la constante prédéterminée K, il est possible de définir, en fonction des autres éléments de l'interface $118_1$, le taux de variation de courant $i_{DS1}$ maximal, c'est-à-dire celui à partir duquel la résistance d'interface $R_I$ prendra sa valeur maximale $R_{I_max}$. Plus précisément, en considérant le seuil S de la tension $V_{gs1}$ à partir duquel le composant résistif $120_1$ est ouvert (résistance Rv très grande), il est possible de définir le taux de variation négatif maximal $\left(\frac{di_{DS1}}{dt}\right)_{max}$ du courant $i_{DS1}$, c'est-à-dire celui pour lequel la résistance d'interface $R_I$ est maximale (valant $R_{I_max}$) :

$$\left(\frac{di_{DS1}}{dt}\right)_{max} = \frac{S}{K \cdot L_1}$$

Le circuit de commande $122_1$ comporte en outre une inductance $C_1$ connectée entre la grille $g_1$ et la source $s_1$ pour lisser les variations de la tension grille-source $V_{gs1}$ et pour ralentir la contre-réaction.

Il sera apprécié que, alternativement, le circuit de mesure $124_1$ pourrait être connecté aux bornes de l'inductance parasite (non représentée) située du côté du drain $D_1$ de l'interrupteur $104_1$. Cependant, du fait qu'à l'ouverture de l'interrupteur $104_1$ la tension drain-source $V_{DS1}$ s'accroît très rapidement et du fait qu'il existe des capacités parasites intrinsèque au transformateur $T_1$, des courants parasites risqueraient d'apparaitre entre le drain $D_1$ et la grille $G_1$, ces courants parasites perturberaient le fonctionnement de l'interface $118_1$. Le placement du circuit de mesure $124_1$ aux bornes de l'inductance $L_1$ située du côté de la source $S_1$ permet de résoudre ce problème.

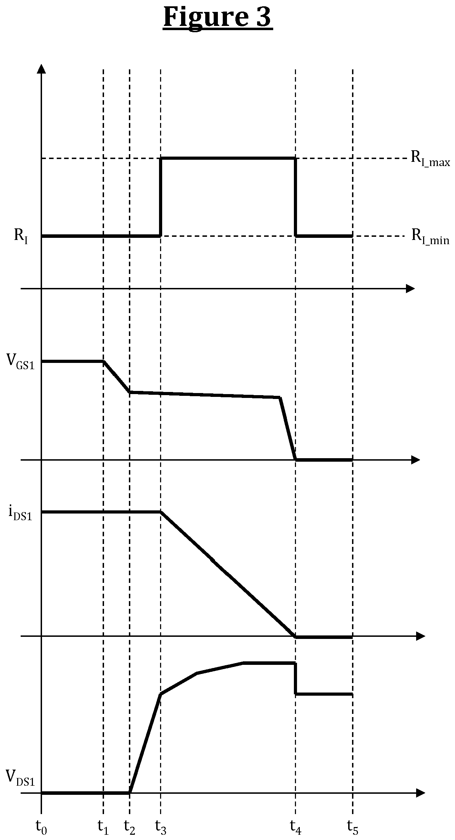

En référence à la figure 3, le fonctionnement du dispositif de commande $112_1$ va à présent être décrit.

À un instant initial $t_0$, l'interrupteur $104_1$ est à l'état fermé. La tension de pilotage $V_{P1}$ et la tension grille-source $V_{GS1}$ sont à la valeur de fermeture (10 V). La tension drain-source $V_{DS1}$ est nulle et le courant $i_{DS1}$ est non nul et constant et se dirige vers le point milieu $P_1$. Ainsi, la tension d'inductance $V_{L1}$ est nulle, de même que la tension grille-source $V_{gs1}$, de sorte que le composant résistif $120_1$ est à l'état fermé. La résistance variable $R_V$ est donc nulle et la résistance d'interface $R_I$ est à sa valeur minimum $R_{I\_min}$.

À un instant $t_1$, la tension de pilotage $V_{P1}$ passe à la valeur basse. Comme la résistance d'interface $R_I$ est à sa valeur minimum $R_{I\_min}$, la tension $V_{GS1}$ diminue rapidement et atteint un plateau.

À un instant $t_2$, la tension drain-source $V_{DS1}$ commence à augmenter.

À un instant $t_3$, le courant drain-source $i_{DS1}$ commence à diminuer. À cet instant, la tension d'inductance $V_{L1}$ devient non nulle et augmente entraînant une surtension sur la tension $V_{DS1}$. Néanmoins, cette surtension est limitée par le fait que la tension d'inductance $V_{L1}$ est mesurée par le circuit de mesure $124_1$ qui fournit une tension de mesure $V_{M1}$. Ainsi, la tension grille-source $V_{gs1}$ qui est égale à $K \cdot L_1 \cdot \frac{di_{DS1}}{dt}$ devient négative, de sorte que le composant résistif $120_1$ commute vers l'état ouvert et que sa résistance variable $R_V$ augmente. Ainsi, la résistance d'interface $R_I$ tend vers sa valeur maximum $R_{I\_max}$ ce qui a pour effet de diminuer le courant de décharge $i_{G1}$ et donc de ralentir la commutation de l'interrupteur $104_1$.

Ainsi, le courant drain-source $i_{DS1}$ diminue lentement, à un taux de variation inférieur ou égal au taux de variation négatif maximal $\left(\frac{di_{DS1}}{dt}\right)_{max}$ défini ci-dessus, de sorte que la tension d'inductance $V_{L1}$ n'est pas très élevée. La surtension de $V_{DS1}$ est donc limitée.

À un instant $t_4$, le courant drain-source $i_{DS1}$ s'annule. Ainsi, la tension d'inductance $V_{L1}$ devient nulle et la résistance d'interface $R_I$ repasse à sa valeur minimale $R_{I\_min}$. La tension grille-source $V_{GS1}$ s'annule et la tension drain-source $V_{DS1}$ diminue jusqu'à la tension de batterie $V_{BAT}$.

L'interrupteur $104_1$ est alors dans son état ouvert.

Grâce à l'invention, la vitesse de commutation de l'interrupteur $104_1$ est ralentie au moment opportun c'est-à-dire lors de l'apparition de la surtension, entre $t_3$ et $t_4$. En revanche, le reste du temps, la vitesse de commutation reste rapide. En particulier, lors de la fermeture de l'interrupteur $104_1$, le courant drain-source $i_{DS1}$ augmente de sorte que la tension d'inductance $V_{L1}$ change de sens, comme la tension de mesure $V_{M1}$. Ainsi, la tension grille-source $V_{gs1}$ du composant résistif $120_1$ devient positive de sorte que la résistance variable $R_V$ reste nulle et que la résistance d'inductance $R_I$ reste à sa valeur minimum $R_{I\_min}$. Ainsi, la fermeture de l'interrupteur $104_1$ se fait à vitesse élevée.

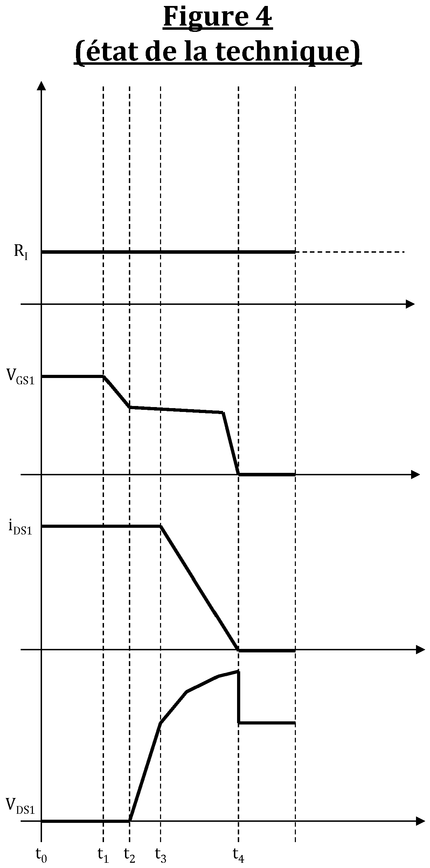

En référence à la figure 4, dans le cas de l'état de la technique où la résistance d'interface $R_I$ reste constante durant toute l'ouverture de l'interrupteur, on obtient soit, dans le cas où la résistance d'interface $R_I$ est choisie faible (cas de la figure 4), une commutation rapide mais une surtension importante, soit, dans le cas où la résistance d'interface $R_I$ est choisie élevée, une surtension limitée mais une commutation lente.

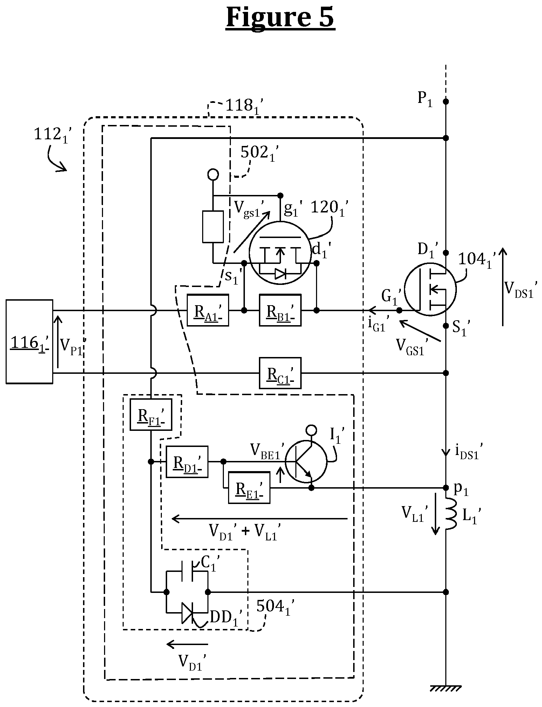

En référence à la figure 5, une variante de circuit de commande $502_1$' de l'interrupteur $104_1$' va à présent être décrite.

Le circuit de commande $502_1$' comporte un interrupteur commandable $I_1$' présentant une première borne connectée à la borne $g_1$' du composant résistif $120_1$' et une deuxième borne connectée à un point $p_1$ entre l'interrupteur $104_1$' et l'inductance $L_1$'. L'interrupteur commandable $I_1$' est conçu pour prendre un état ouvert dans lequel la borne $g_1$' du composant résistif $120_1$' est déconnectée et un état fermé dans lequel la borne $g_1$' du composant résistif $120_1$' est connectée au point $p_1$. L'interrupteur commandable $I_1$' présente en outre une borne de commande dont la tension par rapport à la deuxième borne commande son état. Dans l'exemple décrit, l'interrupteur commandable $I_1$' est un transistor bipolaire à grille isolée (de l'anglais « Insulated Gate Bipolar Transistor » donnant l'acronyme IGBT) présentant un collecteur, un émetteur et une base formant respectivement la première borne, la deuxième borne et la borne de commande. Ainsi, la tension de commande de l'interrupteur commandable $I_1$' est sa tension base-émetteur

$V_{BE1}$' et l'interrupteur commandable $I_1$' passe à l'état fermé lorsque la tension $V_{BE1}$' dépasse un seuil prédéterminé.

Le circuit de commande $502_1$' est conçu pour commander l'interrupteur commandable $I_1$' à partir de la tension d'inductance $V_{L1}$', lorsque le courant principal $i_{DS1}$' diminue, afin de fermer l'interrupteur commandable $I_1$'.

Ainsi, le circuit de commande $502_1$' comporte un pont diviseur de tension comportant deux résistances $R_{D1}$', $R_{E1}$' connectées aux bornes de l'inductance $L_1$' pour recevoir la tension $V_{L1}$'. La deuxième borne et la borne de commande sont connectés aux bornes de la résistance $R_{E1}$', de sorte que la tension $V_{BE1}$' devrait valoir :

$$V'_{BE1} = \frac{R_{D1}' \cdot R_{E1}'}{R_{D1}' + R_{E1}'} V_{L1}'$$

Cependant, pour les petites valeurs de $V_{L1}$', la tension $V_{BE1}$' ne dépasse pas le seuil de fermeture. Ainsi, lorsque le courant $i_{DS1}$' commence à diminuer le composant résistif $120_1$' n'est pas commandé.

Pour pallier ce problème, le circuit de commande $502_1$' comporte en outre un circuit de pré-charge $504_1$' conçu pour appliquer une tension de commande prédéterminée en l'absence de diminution du courant principal $i_{DS1}$'. En outre, le circuit de commande $502_1$' est conçu, lorsque le courant principal $i_{DS1}$' diminue, pour appliquer à l'interrupteur commandable $I_1$' une tension de commande $V_{BE1}$' qui est la somme de la tension de commande prédéterminée et d'une tension complémentaire dérivée de la tension d'inductance $V_{L1}$'.

Dans l'exemple décrit, le circuit de pré-charge $504_1$' comporte une résistance $R_{F1}$' connectée entre la résistance $R_{D1}$' et le drain $D_1$' de l'interrupteur $104_1$', et une diode $DD_1$' et une capacité $C_1$' montés en parallèle l'une de l'autre entre la résistance $R_{D1}$' et la borne de l'inductance $L_1$' à l'opposé du point $p_1$.

La diode DD1' est de préférence une diode Schottky à faible seuil, par exemple avec un seuil inférieure à 0,5 V, par exemple de 0,3 V.

Le fonctionnement du système de commande $502_1$' va à présent être décrit.

Initialement, la tension de pilotage $V_{P1}$' et la tension $V_{GS1}$' sont à la valeur de fermeture de l'interrupteur $104_1$'. Ainsi, la tension $V_{DS1}$' est à 0V et le courant $i_{DS1}$' est constant et dirigé vers le point $P_1$. Ainsi, la tension $V_{L1}$ est nulle.

À un instant, la tension de pilotage $V_{P1}$' passe à 0V pour ouvrir l'interrupteur $104_1$'.

Un courant de décharge $i_{G1}$' apparaît et la tension $V_{GS1}$' diminue, tandis que la tension $V_{DS1}$' augmente et que le courant $i_{DS1}$' reste constant.

L'augmentation de la tension $V_{DS1}$' polarise la diode $DD_1$' qui passe à l'état bloqué et présente une tension directe $V_{D1}$'. Ainsi, une tension de commande prédéterminée (proportionnelle à la tension directe $V_{D1}$' par le pont diviseur de tension $R_{D1}$', $R_{E1}$') est appliquée à l'interrupteur $I_1$'. Cette tension de commande prédéterminée a pour but d'amener l'interrupteur $I_1$' à proximité de son seuil de fermeture, par exemple jusqu'à 5% au-delà ou en deçà du seuil de fermeture.

À un instant ultérieur, le courant $i_{DS1}$' commence à diminuer et la tension $V_{L1}$' devient non nulle.

Ainsi, la tension $V_{L1}$' vient s'ajouter à la tension directe $V_{D1}$' de sorte que la tension de commande $V_{BE1}$' passe très rapidement le seuil de fermeture et l'interrupteur $I_1$' passe à l'état fermé très rapidement après que le courant $i_{DS1}$' commence à diminuer.

Ainsi, la borne $g_1$' du composant résistif est connectée au point $p_1$, de sorte que la tension $V_{gs1}$' devient négative provoquant l'augmentation de la résistance variable Rv et donc l'augmentation de la résistance d'interface $R_I$.

La capacité C1' permet de filtrer les parasites rapides (de l'ordre de quelques nano-secondes) présents sur la tension $V_{DS1}$'. Ainsi, seule la varation lente de $V_{DS1}$' est transmise à l'interrupteur commandable $I_1$' ce qui rend ce dernier robuste aux parasites rapides sur la tension $V_{DS1}$'.

La variante illustrée sur la figure 5, peut être utilisée pour les interrupteurs de côté haut $104_1$, $104_2$ et les interrupteurs de côté bas $104_1$', $104_2$' des bras de commutation.

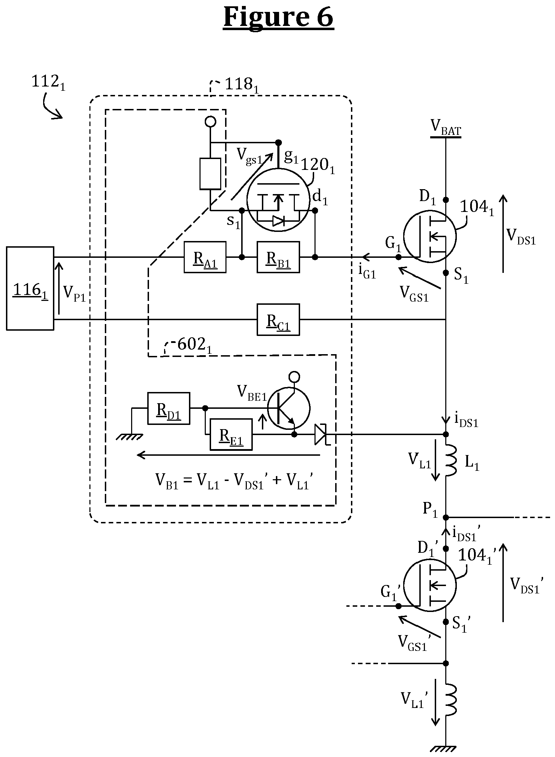

En référence à la figure 6, une variante de circuit de commande $602_1$ va à présent être décrite.

Le circuit de commande $602_1$ est adapté pour commander un composant résistif $120_1$ associé à un interrupteur de côté haut, par exemple l'interrupteur $104_1$ comme illustré sur la figure 6.

Le circuit de commande $602_1$ est similaire à celui de la figure 5, si ce n'est que la résistance $R_{D1}$ est connectée à la masse électrique.

Ainsi, le circuit de commande $602_1$ est connecté aux bornes d'une branche comportant, dans l'ordre : la première inductance $L_1$, le point milieu $P_1$, l'interrupteur $104_1$' et la deuxième inductance $L_1$', afin de recevoir une tension de branche $V_{B1}$ présente aux bornes de cette branche.

Le circuit de commande $602_1$ est conçu pour commander le composant résistif $120_1$ à partir de la tension de branche $V_{B1}$, au lieu d'uniquement la tension $V_{L1}$ comme dans l'exemple de la figure 5.

Le fonctionnement du système de commande $602_1$ va à présent être décrit.

Initialement, la tension de pilotage $V_{P1}$ et la tension $V_{GS1}$' sont à la valeur de fermeture de l'interrupteur $104_1$. Ainsi, la tension $V_{DS1}$ est à 0V et le courant $i_{DS1}$ est constant et dirigé vers le point $P_1$. Ainsi, la tension $V_{L1}$ est nulle. En outre, le courant $i_{DS1}$' est également nul car l'interrupteur $104_1$' est ouvert.

À un instant, la tension de pilotage $V_{P1}$ passe à 0V pour ouvrir l'interrupteur $104_1$.

Un courant de décharge $i_{G1}$ apparaît et la tension $V_{GS1}$ diminue, tandis que la tension $V_{DS1}$ augmente et que le courant $i_{DS1}$ reste constant.

À un instant ultérieur, le courant $i_{DS1}$ commence à diminuer et la tension $V_{L1}$ devient non nulle.

Par ailleurs, comme la bobine de la machine électrique présente une inductance très élevée, le courant partant du point $P_1$ pour entrer dans la bobine reste sensiblement constant. Ainsi, la baisse du courant iDS1 est compensée par l'apparition d'un courant $i_{DS1}'$ dirigé vers le point $P_1$ et croissant. Ainsi, une tension $V_{L1}'$ apparaît aux bornes de l'inductance $L_1'$.

Le circuit de commande $602_1$ reçoit alors la tension de branche $V_{B1}$, qui est égale à : $V_{B1} = V_{L1} - V_{DS1}' + V_{L1}'$ et en dérive, au travers du pont diviseur de tension $R_{D1}$, $R_{E1}$, la tension $V_{BE1}$. La tension $V_{DS1}'$ peut être positive ou négative, mais, même lorsqu'elle est positive, grâce à la présence de la tension $V_{L1}'$ en plus de la tension $V_{L1}$, la tension $V_{BE1}$ passe le seuil de fermeture de l'interrupteur $I_1$ rapidement après que le courant iDS1 commence à diminuer. Comme expliqué précédemment, la fermeture de l'interrupteur $I_1$ entraîne l'ouverture de l'interrupteur $120_1$ et donc l'augmentation de la résistance d'interface $R_I$.

La présente invention n'est pas limitée aux modes de réalisation décrits précédemment, mais est au contraire définie par les revendications qui suivent. Il sera en effet apparent à l'homme du métier que des modifications peuvent y être apportées.

Par ailleurs, les termes utilisés dans les revendications ne doivent pas être compris comme limités aux éléments des modes de réalisation décrits précédemment, mais doivent au contraire être compris comme couvrant tous les éléments équivalents que l'homme du métier peut déduire à partir de ses connaissances générales.

## Revendications

1.  Système d'interrupteur comportant :

    - un interrupteur principal ($104_1$; $104_1'$) présentant :

        - une première borne ($D_1$; $D_1'$) et une deuxième borne ($S_1$; $S_1'$) entres lesquelles un courant principal ($i_{DS1}$; $i_{DS1}'$) est destiné à passer, et
        - une borne de commande ($G_1$; $G_1'$) destinée à se décharger selon une vitesse de décharge en fournissant un courant de décharge ($i_{G1}$; $i_{G1}'$), pour faire passer l'interrupteur principal ($104_1$; $104_1'$) d'un état fermé à un état ouvert,

        - une interface ($118_1$; $118_1'$) présentant une résistance d'interface destinée à être traversée par le courant de décharge ($i_{G1}$; $i_{G1}'$), de sorte que la vitesse de décharge dépende de la résistance d'interface,

le système d'interrupteur étant **caractérisé en ce que** l'interface ($118_1$; $118_1'$) comporte un composant résistif ($120_1$; $120_1'$) présentant une résistance variable participant à la résistance d'interface, et **en ce qu'**il comporte en outre :

    - un circuit de commande ($122_1$; $502_1'$ :$602_1$) du composant résistif ($120_1$; $120_1'$), conçu, lorsque le courant principal ($i_{DS1}$; $i_{DS1}'$) diminue, pour faire varier la résistance variable de sorte que la résistance d'interface augmente, afin de diminuer la vitesse de décharge de la borne de commande ($G_1$; $G_1'$).

2.  Système d'interrupteur selon la revendication 1, dans lequel le composant résistif ($120_1$; $120_1'$) est un interrupteur commandable.

3.  Système d'interrupteur selon la revendication 2, dans lequel l'interrupteur commandable est un MOSFET.

4.  Système d'interrupteur selon la revendication 3, dans lequel l'interrupteur commandable est un MOSFET à déplétion.

5.  Système d'interrupteur selon l'une quelconque des revendications 1 à 4, dans lequel l'interface ($118_1$; $118_1'$) comporte en outre une ou plusieurs résistances fixes ($R_{A1}$, $R_{B1}$, $R_{C1}$; $R_{A1}'$, $R_{B1}'$, $R_{C1}'$) combinée(s) avec le composant résistif ($120_1$; $120_1'$) pour participer à la résistance d'interface.

6.  Système d'interrupteur selon l'une quelconque des revendications 1 à 5, dans lequel le circuit de commande ($122_1$; $502_1'$) est destiné à être connecté aux bornes d'une inductance ($L_1$; $L_1'$) parcourue par le courant principal ($i_{DS1}$; $i_{DS1}'$) afin de recevoir une tension d'inductance ($V_{L1}$; $V_{L1}'$) présente aux bornes de cette inductance ($L_1$; $L_1'$), et dans lequel le circuit de commande ($122_1$; $122_1'$) est conçu pour commander le composant résistif ($120_1$; $120_1'$) à partir de la tension d'inductance ($V_{L1}$; $V_{L1}'$).

7.  Système d'interrupteur selon la revendication 6, dans lequel le circuit de commande ($122_1$) comporte un transformateur ($T_1$) comportant un bobinage primaire connecté aux bornes de l'inductance ($L_1$) et un bobinage secondaire destiné à fournir un signal de mesure ($V_{M1}$) représentatif de la tension d'inductance ($V_{L1}$), le circuit de commande ($122_1$) étant conçu pour commander le composant résistif ($120_1$) à partir de la tension de mesure ($V_{M1}$).

8.  Système d'interrupteur selon la revendication 7, dans lequel le circuit de commande ($122_1$) comporte en outre un circuit multiplicateur ($126_1$) conçu pour multiplier le signal de mesure ($V_{M1}$) par une constante prédéterminée pour fournir une tension de commande ($V_{gs1}$) appliquée au composant résistif ($120_1$).

9. Système d'interrupteur selon la revendication 7 ou 8, dans lequel le bobinage primaire présente une inductance d'au moins 1 $\mu$H.

10. Système d'interrupteur selon la revendication 6, dans lequel le circuit de commande ($502_1'$) comporte un interrupteur commandable ($I_1'$) connecté à une borne de commande ($g1'$) du composant résistif ($120_1'$), et
dans lequel le circuit de commande ($502_1'$) est conçu pour commander l'interrupteur commandable ($I_1'$) à partir de la tension d'inductance ($V_{L1}'$), lorsque le courant principal ($i_{DS1}'$) diminue, afin de fermer l'interrupteur commandable ($I_1'$) pour connecter sa borne de commande ($g_1'$) à un potentiel destiné à faire varier la résistance variable de sorte que la résistance d'interface augmente.

11. Système d'interrupteur selon la revendication 10, dans lequel l'interrupteur commandable ($I_1'$) est conçu pour être commandé en se voyant appliquer une tension de commande ($V_{BE1}'$),
dans lequel le circuit de commande ($502_1'$) comporte un circuit de pré-charge ($504_1'$) conçu pour appliquer une tension de commande prédéterminée en l'absence de diminution du courant principal ($i_{DS1}'$), et
dans lequel le circuit de commande ($502_1'$) est conçu, lorsque le courant principal ($i_{DS1}$) diminue, pour appliquer à l'interrupteur commandable ($I_1'$) une tension de commande ($V_{BE1}'$) qui est la somme de la tension de commande prédéterminée et d'une tension complémentaire dérivée de la tension d'inductance ($V_{L1}$).

12. Convertisseur électrique (100) comportant au moins deux bras de commutation ($102_1$, $102_2$) ayant chacun deux interrupteurs ($104_1$, $104_1'$ ; $104_2$, $104_2'$) connectés l'un à l'autre en un point milieu, et dans lequel chacun d'au moins un des interrupteurs ($104_1$, $104_1'$, $104_2$, $104_2'$), de préférence les deux, fait partie d'un système d'interrupteur selon l'une quelconque des revendications 1 à 11.

13. Bras de commutation comportant :

    - un système d'interrupteur selon l'une quelconque des revendications 1 à 5, l'interrupteur principal ($104_1$) étant appelé premier interrupteur principal ($104_1$),
    - un deuxième interrupteur principal ($104_1'$),

dans lequel le premier interrupteur principal ($104_1$) et le deuxième interrupteur principal ($104_1'$) sont connectés l'un à l'autre en un point milieu ($P_1$) destiné à être connecté à une bobine d'une machine électrique,
dans lequel le premier interrupteur principal ($104_1$) est en outre destiné à être connecté à une borne positive d'une source de tension continue,
dans lequel le deuxième interrupteur principal ($104_1'$) est en outre destiné à être connecté à une borne négative d'une source de tension continue,
dans lequel le circuit de commande ($602_1$) est destiné à être connecté aux bornes d'une branche comportant, dans l'ordre : une première inductance ($L_1$), le point milieu ($P_1$), et une deuxième inductance ($L_1'$), afin de recevoir une tension de branche ($V_{B1}$) présente aux bornes de cette branche, et
dans lequel le circuit de commande ($602_1$) est conçu pour commander le composant résistif ($120_1$) à partir de la tension de branche ($V_{B1}$).

14. Bras de commutation selon la revendication 13, dans lequel le circuit de commande ($602_1$) comporte un interrupteur commandable ($I_1$) connecté à une borne de commande ($g_1$) du composant résistif ($120_1$), et
dans lequel le circuit de commande ($602_1$) est conçu pour commander l'interrupteur commandable ($I_1$) à partir de la tension de branche ($V_{B1}$), lorsque le courant principal ($i_{DS1}$) diminue, afin de fermer l'interrupteur commandable ($I_1$) pour connecter la borne de commande ($g_1$) du composant résistif ($120_1$) à un potentiel destiné à faire varier la résistance variable de sorte que la résistance d'interface augmente.

15. Convertisseur électrique (100) comportant au moins deux bras de commutation ($102_1$, $102_2$) dont l'un au moins est conforme à la revendication 13 ou 14.

# <u>Figure 1</u>

# Figure 2

# Figure 3

$R_I$

$R_{I\_max}$

$R_{I\_min}$

$V_{GS1}$

$i_{DS1}$

$V_{DS1}$

$t_0$   $t_1$   $t_2$   $t_3$   $t_4$   $t_5$

# Figure 4
## (état de la technique)

# Figure 5

# Figure 6

$$V_{B1} = V_{L1} - V_{DS1}' + V_{L1}'$$

Europäisches
Patentamt

European
Patent Office

Office européen
des brevets

**RAPPORT DE RECHERCHE EUROPEENNE**

Numéro de la demande

EP 17 19 7826

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2002/070772 A1 (NEACSU DORIN O [US] ET AL) 13 juin 2002 (2002-06-13) * alinéas [0003] - [0011], [0051] - [0088]; figures 16A,B,17 * ----- | 1-15 | INV. H03K17/082 H03K17/16 |
| X | EP 2 495 875 A1 (NISSAN MOTOR [JP]; CALSONIC KANSEI CORP [JP]) 5 septembre 2012 (2012-09-05) * alinéas [0002] - [0022]; figure 1 * ----- | 1-15 | |
| X | EP 2 003 777 A1 (NISSAN MOTOR [JP]) 17 décembre 2008 (2008-12-17) * alinéas [0009] - [0033]; figure 1 * ----- | 1-15 | |

DOMAINES TECHNIQUES RECHERCHES (IPC)

H03K

Le présent rapport a été établi pour toutes les revendications

| Lieu de la recherche | Date d'achèvement de la recherche | Examinateur |
|---|---|---|
| La Haye | 16 février 2018 | Meulemans, Bart |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 19 7826

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-02-2018

| Document brevet cité au rapport de recherche | | Date de publication | Membre(s) de la famille de brevet(s) | | Date de publication |
|---|---|---|---|---|---|
| US 2002070772 | A1 | 13-06-2002 | AUCUN | | |
| EP 2495875 | A1 | 05-09-2012 | CN | 102687398 A | 19-09-2012 |
| | | | EP | 2495875 A1 | 05-09-2012 |
| | | | JP | 5347032 B2 | 20-11-2013 |
| | | | JP | WO2011052398 A1 | 21-03-2013 |
| | | | KR | 20120085860 A | 01-08-2012 |
| | | | US | 2012206174 A1 | 16-08-2012 |
| | | | WO | 2011052398 A1 | 05-05-2011 |
| EP 2003777 | A1 | 17-12-2008 | CN | 101320939 A | 10-12-2008 |
| | | | EP | 2003777 A1 | 17-12-2008 |
| | | | JP | 4752811 B2 | 17-08-2011 |
| | | | JP | 2008306807 A | 18-12-2008 |
| | | | US | 2008304197 A1 | 11-12-2008 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- WO 2014009668 A1